# EUROPÄISCHE PATENTSCHRIFT

(11) **EP 3 997 730 B1**
(45) Veröffentlichungstag und Bekanntmachung des Hinweises auf die Patenterteilung: **30.08.2023**
(21) Anmeldenummer: 20739312.5
(22) Anmeldetag: 07.07.2020
(51) Int. Cl.: H01L 21/48, H01L 23/473

(54) **VERFAHREN ZUR HERSTELLUNG EINES KÜHLELEMENTS UND KÜHLELEMENT HERGESTELLT MIT EINEM SOLCHEN VERFAHREN**
METHOD FOR PRODUCING A COOLING ELEMENT, AND COOLING ELEMENT PRODUCED USING SUCH A METHOD
PROCÉDÉ DE FABRICATION D'UN ÉLÉMENT DE REFROIDISSEMENT ET ÉLÉMENT DE REFROIDISSEMENT FABRIQUÉ AVEC UN TEL PROCÉDÉ

(30) Priorität: 11.07.2019 DE 102019118835
(43) Veröffentlichungstag der Anmeldung: 18.05.2022
(73) Patentinhaber: Rogers Germany GmbH, 92676 Eschenbach (DE); Trumpf Photonics, Inc., Cranbury, NJ 08512 (US)
(72) Erfinder: WIESEND, Johannes, 92676 Speinshart (DE); MACHER, Michael, 92637 Weiden (DE); SCHWEIGER, Heiko, 95519 Oberbibrach (DE); VETHAKE, Thilo, New Jersey, New Jersey 08555 (US); GOTTDIENER, Mark, New Jersey, New Jersey 08690 (US)
(74) Vertreter: Müller Schupfner & Partner Patent- und Rechtsanwaltspartnerschaft mbB
(86) Internationale Anmeldenummer: PCT/EP2020/069049
(87) Internationale Veröffentlichungsnummer: WO 2021/005024

(56) Entgegenhaltungen:
- GB-A- 1 515 658
- US-A- 5 718 286
- US-A- 5 727 618
- US-A1- 2003 152 488

## Beschreibung

Die vorliegende Erfindung betrifft ein Verfahren zur Herstellung eines Kühlelements und ein Kühlelement hergestellt mit einem solchen Verfahren.

Aus dem Stand der Technik sind Kühlelemente zum Kühlen von elektrischen bzw. elektronischen Bauteilen, insbesondere Halbleitern, wie z. B. Laserdioden, hinlänglich bekannt. Dabei entwickeln die elektrischen bzw. elektronischen Bauteile während ihres Betriebs Wärme, die mittels des Kühlelements abgeführt wird, um so wiederum eine dauerhafte Funktionalität der elektrischen bzw. elektronischen Bauteile zu gewährleisten. Dies trifft insbesondere für Laserdioden zu, bei denen bereits Temperaturunterschiede von wenigen °C zu signifikanten Beeinträchtigungen der Leistung und/oder Lebensdauer führen können.

Zum Kühlen der Bauteile weisen die Kühlelemente, die in der Regel an die Bauteile angebunden sind, typischerweise ein Kühlfluidkanalsystem auf, durch das im Betrieb ein Kühlfluid geleitet wird, um vom elektrischen bzw. elektronischen Bauteil ausgehende Wärme aufzunehmen und abzutransportieren. Vorzugsweise wird hierbei eine Finnenstruktur verwendet, bei der mehrere stegartige Elemente in das Kühlfluidkanalsystem hineinragen, um eine möglichst große Kontaktfläche zum Kühlfluid bereitzustellen, wodurch die Wärmeübertragung von Wandungen, die das Kühlfluidkanalsystem begrenzen, auf das Kühlfluid verbessert wird.

Entsprechend ist es erstrebenswert, möglichst viele dieser stegartigen Elemente auf möglichst kleinstem Raum zu vereinen, um für eine optimale Kühlleistung am Übergang zwischen Finnenstruktur und Fluid zu sorgen.

Begrenzt wird ein solches möglichst nahes Anordnen von benachbarten, stegartigen Elementen durch einen kleinstmöglichen Abstand, der zwischen zwei benachbarten stegartigen Elementen durch das Herstellungsverfahren realisierbar ist.

Typischerweise werden die stegartigen Elemente durch ein entsprechendes Ätzen einer Ausnehmung in einer Metallschicht realisiert, die die elektrischen bzw. elektronischen Bauteile direkt oder indirekt über z. B. ein Keramik-Metall-Substrat trägt, wobei die Metallschicht und ggf. anders strukturierte Metallschichten entlang einer Stapelrichtung übereinandergestapelt werden, um das Kühlelement mit dem Kühlfluidkanalsystem zu bilden.

Es hat sich dabei herausgestellt, dass mit möglichst dünnen Metallschichten vergleichsweise geringe Abstände zwischen benachbarten, stegartigen Elementen realisierbar sind, so dass es sich etabliert hat, mehrere, vorzugsweise zwei bis drei, möglichst dünne Metallschichten übereinanderzustapeln, um so stegartige Elemente mit einer ausreichend großen Ausdehnung entlang der Stapelrichtung und gleichzeitig einem geringen Abstand zwischen zwei benachbarten stegartigen Elementen zu erhalten. Allerdings ist bei einem solchen Vorgehen wegen eines auftretenden Versatzes, in einer Richtung senkrecht zur Stapelrichtung zwischen den übereinandergestapelten Metallschichten, ein minimaler Abstand zwischen zwei benachbarten stegartigen Elementen auf 0,3 mm oder größer begrenzt.

Ferner ist es aus US 5 727 618 A bekannt, eine Kühlstruktur aus mehreren Metalllagen zu bilden, wobei die einzelne Metalllage mittels eines Drahterodierens bearbeitet wird. Aus der US 5,718,286 ist es bekannt eine Kühlstruktur aus mehreren Metalllagen zu bilden, wobei die einzelnen Metalllagen Aussparungen zur Bildung eines Kühlkanals aufweisen. Die GB 1 515 658 A betrifft eine Kühldose für einen Thyristor, mit wenigstens einer Wärmeübergangsfläche, die zur wärmeleitenden Verbindung mit dem Thyristor bestimmt ist und mit einem Kern aus Metall, in dem Strömungswege für ein Kühlmedium von einer Einlass- zu einer Auslassöffnung verlaufen. In der US 2003 152488 A1 wird das Ätzen von Metallschichten offenbart.

Hiervon ausgehend macht es sich die vorliegende Erfindung zur Aufgabe, ein Kühlelement bereitzustellen, das gegenüber den aus dem Stand der Technik bekannten Kühlelementen eine verbesserte Kühlwirkung aufweist, bei dem insbesondere feiner strukturierte Ausnehmungen für das Kühlfluidkanalsystem möglich sind.

Diese Aufgabe wird gelöst durch ein Verfahren gemäß Anspruch 1 und ein Kühlelement gemäß Anspruchs 13. Weitere Vorteile und Eigenschaften der Erfindung ergeben sich aus den Unteransprüchen sowie der Beschreibung und den beigefügten Figuren.

Gemäß einem ersten Aspekt der vorliegende Erfindung ist ein Verfahren zur Herstellung eines Kühlelements für ein elektrisches oder elektronisches Bauteil, insbesondere ein Halbleiterelement, vorgesehen, wobei das gefertigte Kühlelement ein Kühlfluidkanalsystem aufweist, durch das im Betrieb ein Kühlfluid durchleitbar ist, umfassend
- Bereitstellen mindestens einer ersten Metallschicht,
- Realisieren mindestens einer Ausnehmungen in der mindestens einen ersten Metallschicht, und
- Ausbilden zumindest eines Teilabschnitts des Kühlfluidkanalsystem mittels der mindestens einen Ausnehmung,
wobei mindestens ein erster Teil der mindestens einen Ausnehmung in der mindestens einen ersten Metallschicht durch Erodieren, insbesondere Funkenerodieren, realisiert wird.

Gegenüber den aus dem Stand der Technik bekannten Verfahren ist es erfindungsgemäß vorgesehen, durch Erodieren, insbesondere durch Funkenerodieren (z. B. Draht- oder Senkenerodieren), zumindest einen Teil der mindestens einen Ausnehmung in der mindestens einen ersten Metallschicht zu realisieren. Das Erodieren erlaubt es insbesondere sehr kleine bzw. feinstrukturierte Ausnehmungen bzw. Ausnehmungsabschnitte auszuformen, bei denen insbesondere auch Ausnehmungsteilabschnitte, d. h. erste Teile der mindestens einen Ausnehmung, realisierbar sind, bei denen ein Abstand zwischen zwei gegenüberliegenden Seitenflächen, beispielsweise von benachbarten stegartigen Elementen, in der mindestens einen ersten Metallschicht ein Wert zuzuordnen ist, der kleiner als 0,3 mm ist. In entsprechender Weise lassen sich in einer einzelnen ersten Metallschicht Ausnehmungen realisieren, die im später gefertigten Kühlfluidkanalsystem einen sehr schmalen Kanalabschnitt bzw. einen sehr schmalen Abschnitt ausbilden, durch den das Kühlfluid geleitet werden kann, insbesondere ohne dass mehrere erste Metallschichten übereinander gestapelt werden müssen. Infolgedessen lassen sich sehr viel kleinere und schmalere Kühlstrukturen, z.B. Finnenstrukturen im Kühlelement, im Vergleich zu denjenigen, die aus dem Stand der Technik bekannt sind, herstellen, sodass eine Kühlwirkung des Kühlelements signifikant verbessert werden kann.

Vorzugsweise handelt es sich bei dem Funkenerodieren bzw. dem Erodieren um ein thermisches Abtragen für leitfähige Materialien, wobei das Verfahren auf elektrischen Entladevorgängen (Funken) zwischen einer Elektrode als Werkzeug und der mindestens einen ersten Metallschicht beruht. Insbesondere erfolgt das Funkenerodieren gemäß dem Abtragen nach der Norm DIN 8580. Die mindestens eine Ausnehmung in der mindestens einen ersten Metallschicht kann sich durch die gesamte mindestens eine erste Metallschicht hindurcherstrecken (vorzugsweise hergestellt mittels eines Drahterodieren), oder die mindestens eine Ausnehmung in der mindestens einen ersten Metallschicht ist sacklochartig ausgeformt (beispielsweise realisiert durch ein Senkerodieren in der mindestens einen ersten Metallschicht).

Beim Erodieren erfolgt die Bearbeitung, vorzugsweise in einem nicht-leitenden Medium, beispielsweise in Öl oder de-ionisiertem Wasser. Das Elektrodenwerkzeug wird dann auf 0,004 bis 0,5 mm an das Werkstück, d. h. an die zumindest eine erste Metallschicht herangeführt. Anschließend wird gezielt ein Überschlag von Funken durch eine Erhöhung einer anliegenden Spannung veranlasst, woraufhin die erzeugten Funken das Material punktförmig aufschmelzen und verdampfen lassen, sodass die mindestens eine Ausnehmung in der mindestens einen ersten Metallschicht realisiert wird. Weiterhin ist es bevorzugt vorgesehen, dass das Kühlelement eine Anschlussfläche aufweist, an der das elektrische bzw. das elektronische Bauteil angebunden werden kann, wobei der mindestens eine erste Teil der mindestens einen ersten Ausnehmung in der mindestens einen ersten Metallschicht an diese Anschlussfläche angrenzt. D. h. der durch Erodieren hergestellte erste Teil der mindestens einen Ausnehmung grenzt an die Anschlussfläche an und/oder ist in deren Nähe ausgebildet.

Besonders bevorzugt ist das Halbleiterelement eine Laserdiode, für die die Kühleffizienz für dessen Leistungseffizienz und Lebensdauer signifikant entscheidend ist. Weiterhin ist es vorstellbar, dass der erste Teil, der mittels Erodieren hergestellt wird, im später gefertigten Kühlelement Teil einer Finnenstruktur ist. Beispielsweise bildet der erste Teil einen Zwischenraum zwischen zwei stegartigen Elementen aus, die ein Teil der Finnenstruktur sind, durch die das Kühlfluid für eine wirkungsvolle Abführung der Wärme hindurchgeführt wird.

Vorzugsweise ist es weiterhin vorgesehen, dass das Verfahren ferner umfasst:
- Bereitstellen mindestens einer zweiten Metallschicht und
- Stapeln der mindestens einen ersten Metallschicht und der mindestens einen zweiten Metallschicht entlang einer Stapelrichtung unter Ausbildung des mindestens einen Teilabschnitts des Kühlfluidkanals.

Insbesondere ist es vorgesehen, dass die mindestens eine erste Metallschicht und/oder die mindestens eine zweite Metallschicht sich entlang einer Haupterstreckungsebene erstrecken und entlang einer senkrecht zur Haupterstreckungsebene verlaufenden Stapelrichtung übereinandergestapelt werden.

Vorzugsweise umfasst das Kühlelement mindestens eine dritte Metallschicht, die sich ebenfalls entlang einer Haupterstreckungsebene erstreckt und in einer senkrecht zur Stapelrichtung zusammen mit der mindestens einen ersten Metallschicht und der mindestens einen zweiten Metallschicht übereinandergestapelt angeordnet ist. Dabei ist es insbesondere vorgesehen, dass sich die mindestens eine erste Metallschicht, die mindestens eine zweite Metallschicht und die mindestens eine dritte Metallschicht hinsichtlich der Lage und Form der mindestens einen Ausnehmung voneinander unterscheiden. Insbesondere ist es vorgesehen, dass die übereinander angeordneten mindestens eine erste Metallschicht, mindestens eine zweite Metallschicht und/oder mindestens eine dritte Metallschicht im gestapelten Zustand das Kühlfluidkanalsystem ausbilden, durch welches das Kühlfluid während des Betriebs leitbar ist, um die Wärme von der Anschlussfläche wegzuführen.

Vorzugsweise wird in der mindestens einen ersten Metallschicht, der mindestens einen zweiten Metallschicht und/oder der mindestens einen dritten Metallschicht zumindest ein erster Teil der mindestens einen Ausnehmung durch Erordieren hergestellt. Ferner weist das Kühlfluidkanalsystem insbesondere einen Zuleitungsbereich und einen Ableitbereich auf, die sich beispielsweise durch die mindestens eine erste Metallschicht, die mindestens eine zweite Metallschicht und/oder die mindestens eine dritte Metallschicht hindurcherstrecken, wobei das Kühlfluidkanalsystem vorzugsweise derart ausgebildet ist, dass bei der Überführung des Kühlfluides von dem Zuleitungsbereich in den Ableitbereich das Kühlfluid den ersten Teil der Ausnehmung, der durch das Erodieren erstellt worden ist, passieren muss. Vorzugsweise passiert das Kühlfluid die Finnenstruktur beim Übergang vom Zuleitungsbereich zum Ableitbereich. Insbesondere ist es vorgesehen, dass das Kühlfluid entlang der Stapelrichtung das Kühlfluidkanalsystem durchsetzt, insbesondere die Finnenstruktur entlang der Stapelrichtung passiert.

Weiterhin ist das Kühlfluidkanalsystem derart ausgelegt, dass das durch das Kühlfluidkanalsystem geleitete Fluid von der mindestens einen ersten Metallschicht über die zumindest eine zweite Metallschicht bis in die mindestens eine dritten Metallschicht geleitet wird, woraufhin das Fluid in der mindestens dritten Metallschicht umgelenkt wird und wieder in die mindestens eine zweite Metallschicht und/oder mindestens eine erste Metallschicht zurückgeführt wird. Hier hat das Kühlfluid wieder Zugang zum Ableitbereich des Kühlfluidkanalsystems und lässt sich entsprechend aus dem Kühlfluidkanalsystem ableiten. Alternativ ist es vorstellbar, dass die erste Metallschicht und/oder die zweite Metallschicht eine Finnenstruktur bilden, bei der Finnen in einen Fluidkanal hineinragen, an dem das Kühlfluid entlang einer einzigen Strömungsrichtung vorbeigeführt wird. Grundsätzlich sind verschiedenste Gestaltungen von Kühlfluidkanalsystemen vorstellbar, bei denen die stegartigen Elemente mittels Erodieren hergestellt werden.

Neben der mindestens einen ersten Metallschicht, der mindestens einen zweiten Metallschicht und/oder der mindestens einen dritten Metallschicht sind weitere entsprechende Metallschichten und/oder eine obere Deckschicht und/oder eine untere Deckschicht vorgesehen. Sofern eine Isolation zwischen Kühlelement und elektrischen bzw. elektronischen Bauteil erforderlich ist, ist es bevorzugt vorgesehen, dass das obere Deckelement und/oder das untere Deckelement als Metall-Keramik-Verbund ausgebildet ist, bei dem vorzugsweise eine Keramikschicht zwischen zwei Metallschichten angeordnet ist um für die entsprechende Isolation zu sorgen. Im Gegensatz zu der mindestens einen ersten Metallschicht, der mindestens einen zweiten Metallschicht und der mindestens einen dritten Metallschicht kann die obere Deckschicht und/oder die untere Deckschicht keinen ersten Teil der mindestens einen Ausnehmung aufweisen, der durch Erodieren erstellt wird. Stattdessen weist die obere bzw. untere Deckschicht Ausnehmungen bzw. weitere Ausnehmungen auf, die als Eingangsöffnung bzw. Ausgangsöffnung für den Zuleitungsbereich bzw. Ableitbereich des Kühlfluidkanalsystems vorgesehen sind und/oder als Befestigungsmittel und Arretierungshilfen für das Kühlelement.

Erfindungsgemäß ist es vorgesehen, dass mindestens ein zweiter Teil der Ausnehmung in der mindestens einen ersten Metallschicht durch Ätzen realisiert wird. Dadurch ist es in vorteilhafter Weise möglich, die mindestens eine Ausnehmung zweistufig auszubilden, wobei in einem ersten Vorbereitungsschritt, beispielsweise durch ein Ätzen ein großflächiger Abschnitt bzw. der zweite Teil der Ausnehmung gebildet wird. Da insbesondere für die großflächigen Abschnitte der Abstand zwischen zwei gegenüberliegenden Seitenwänden nicht möglichst klein ausgestaltet werden muss, erweist es sich als vorteilhaft, hier auf das etablierte Ätzen zurückzugreifen, wohingegen die feinstrukturierten Ausnehmungsabschnitte bzw. ersten Teile der Ausnehmungen durch Erodieren hergestellt werden, vorzugsweise in einem sich an das Ätzen anschließenden Fertigungsprozess. Auf diese Weise lässt sich das aufwendige Erodieren auf einen möglichst kleinen Teilabschnitt in der mindestens einen ersten Metallschicht begrenzen. Dies wirkt sich positiv auf Herstellungszeit und Herstellungskosten aus.

Vorzugsweise ist es vorgesehen, dass das Ätzen zur Ausbildung des mindestens einen zweiten Teils der mindestens einen Ausnehmung in der mindestens einen ersten Metallschicht zeitlich vor dem Bilden des mindestens einen ersten Teils der mindestens einen Ausnehmung in der mindestens einen ersten Metallschicht erfolgt. Dadurch wird in vorteilhafter Weise mit dem Erstellen des zweiten Teils der Zugang für das Erodieren zur Bildung des ersten Teils vereinfacht, da beispielsweise ein Draht in den bereits geätzten zweiten Teil einfach eingeführt werden kann, um anschließend die gewünschte Struktur für den ersten Teil mittels Erodieren zu veranlassen.

Nach einer Ausführungsform der Erfindung ist es vorgesehen, dass der mindestens erste Teil im gefertigten Zustand gegenüberliegende Seitenwände aufweist, deren Abstand unterhalb eines ersten Schwellenwerts liegt und/oder der mindestens zweite Teil im gefertigten Zustand gegenüberliegende Seitenwände aufweist, deren Abstand oberhalb eines zweiten Schwellenwerts liegt. Vorzugsweise entspricht der erste Schwellenwert dem zweiten Schwellenwert. Entsprechend ist es möglich, den ersten Teil der mindestens einen ersten Ausnehmung von dem mindestens zweiten Teil der mindestens einen Ausnehmung abzugrenzen und entsprechend der erforderlichen Abstände bzw. Dimensionierung der jeweiligen Teilabschnitte das entsprechende Verfahren anzuwenden, das einerseits die möglichst geringen Abstände im ersten Teil gewährleistet, wohingegen im zweiten Teil wegen der größeren Abstände zwischen zwei gegenüberliegenden Seitenwände nicht auf das aufwendige Erodieren zurückgegriffen werden muss.

Nach einer Ausführungsform der Erfindung ist es vorgesehen, dass mehrere erste Metallschichten gleichzeitig erodiert werden. Insbesondere ist es vorgesehen, mittels eines Drahterodierens gleichzeitig in mehreren übereinander gestapelten ersten Metallschichten jeweils den ersten Teil der Ausnehmung zu realisieren, sodass in einem einzelnen Erodierschritt mehrere erste Metallschichten mit dem ersten Teil der Ausnehmung versehen werden. Insbesondere hat es sich herausgestellt, dass bis zu 40 Metallschichten gleichzeitig erodiert werden können. Dies entspricht insbesondere einer Gesamtdichte der übereinandergestapelten ersten Metallschichten von etwa 4 cm. Entsprechend lassen sich in einem Erodierschritt dann bis zu 40 erste Metallschichten realisieren, die dann jeweils später Bestandteil eines Kühlelements werden.

Nach einer Ausführungsform der Erfindung ist es vorgesehen, dass die mehreren ersten Metallschichten in einem Spannelement fixiert werden. Mittels des Spannelements ist es in vorteilhafter Weise möglich, die übereinandergestapelten ersten Metallschichten gemeinsam zu transportieren und insbesondere gemeinsam dem Erodieren zur Verfügung zu stellen bzw. bereitzustellen. Hierzu ist das Spannelement insbesondere mit Öffnungen versehen, die den Zugriff auf die mehreren ersten Metallschichten gewährleistet, sodass ein gleichzeitiges Erodieren mehrerer erster Metallschichten möglich ist. Dabei sind insbesondere mehrere erste Metallschichten zwischen einer ersten Fixierhälfte und einer zweiten Fixierhälfte des Spannelements angeordnet.

Nach einer Ausführungsform der Erfindung ist es vorgesehen, dass die mindestens eine erste Metallschicht eine in Stapelrichtung gemessene Dicke von mehr als 0,3 mm, bevorzugt mehr als 0,4 mm und besonders bevorzugt mehr als 0,8 mm aufweist. Im Gegensatz zu den aus dem Stand der Technik bekannten Verfahren, bei dem mehrere dünne mindestens erste Metallschichten aufeinandergelegt werden, ist es in vorteilhafter Weise möglich, beim Erodieren erste Metallschichten mit Ausnehmung zu versehen, die vergleichsweise dick sind, insbesondere Dicken aufweisen, die größer sind als 0,3 mm. Dadurch lassen sich insbesondere sehr schmale, aber tiefe Strukturierungen in der mindesten einen ersten Metallschicht realisieren, ohne das es erforderlich ist, mehrere erste Metallschichten übereinanderzustapeln. Dies vereinfacht den Fertigungsprozess und erhöht die Stabilität und Ausprägung der Finnenstruktur, die durch den ersten Teil der mindestens einen Ausnehmung in der mindestens einen ersten Metallschicht ausgebildet wird.

Bevorzugt ist es vorgesehen, dass die mindestens eine erste Metallschicht und/oder die mindestens eine zweite Metallschicht zwischen einer unteren Deckschicht und einer oberen Deckschicht angeordnet wird. Mit anderen Worten: die mindestens eine erste Metallschicht und/oder zweite Metallschicht bilden keine obere und untere Deckschichten. Insbesondere ist es in diesem Fall vorgesehen, dass die mindestens eine erste Metallschicht eine Dicke von mehr als 0,3 mm, bevorzugt mehr als 0,4 mm und besonders bevorzugt mehr als 0,8 mm aufweist. Es hat sich schließlich gezeigt, dass auch mit entsprechend dicken ersten Metallschicht zwischen der oberen und unteren Deckschicht ein betriebssicherer Fluidkanal erstellen lässt, der sich zudem einfach zusammensetzt, ohne dass Gefahr besteht, dass ein lateraler Versatz der einzelnen Schichten zueinander zu einer Verengung im gefertigten Fluidkanal führt. Dadurch lassen sich besonders schmale Fluidkanäle im Inneren der Kühlstruktur realisieren.

Weiterhin ist es bevorzugt vorgesehen, dass mehr als drei, bevorzugt mehr als fünf und besonders bevorzugt mehr als sieben erste Metallschichten und/oder zweite Metallschichten vorgesehen sind, deren Dicke größer als 0,3 mm ist. Mit anderen Worten: Die Nutzung von vergleichsweise dicken ersten und/oder zweiten Metallschichten ist nicht auf einzelne Schichten beschränkt, wie beispielsweise eine außenliegende Deckschicht bzw. Teilschicht.

Gemäß einer weiteren Ausführungsform der vorliegenden Erfindung ist es vorgesehen, dass alle erste Metallschichten und/oder zweite Metallschichten eine Dicke von mehr als 0,3 mm, bevorzugt mehr als 0,4 mm und besonders bevorzugt mehr als 0,8 mm aufweisen. Beispielsweise ist es vorgesehen, dass alle ersten und/oder zweiten Metallschichten eine Dicke von 0,5 mm +/- 0,2, bevorzugt von 1 mm +/- 0,4 mm und besonders bevorzugt von 1,2 mm +/- 0,5 mm aufweisen.

Vorzugsweise ist es vorgesehen, dass die Formen der mindestens einen Ausnehmung für mindestens drei, bevorzugt mindestens fünf und besonders bevorzugt mindestens acht erste Metallschichten unterschiedlich sind. Es hat sich in vorteilhafter Weise herausgestellt, dass auch komplexe Kühlsystem durch das Stapeln der mindestens einen ersten Metallschicht und/oder der mindestens einen zweiten Metallschicht realisierbar sind, wenn sie insbesondere vergleichsweise dick sind und dünne Ausnehmungen aufweisen.

Weiterhin ist es vorzugsweise vorgesehen, dass die mindestens eine erste Metallschicht mit der mindestens einen zweiten Metallschicht vorzugsweise durch Sintern stoffschlüssig verbunden wird. Insbesondere ist es vorgesehen, dass die mindestens eine erste Metallschicht mit der mindestens einen zweiten Metallschicht, besonders bevorzugt mit der mindestens einen dritten Metallschicht, ohne die Verwendung eines Haftvermittlers oder eines Lötmaterials miteinander verbunden wird. Beispielsweise werden sie durch ein entsprechendes Erhitzen derart miteinander verbunden, dass sich ein monolithischer Grundkörper für das Kühlelement ausbilden.

Weiterhin ist es bevorzugt vorgesehen, dass eine einzige erste Metallschicht zur Bildung des Kühlelements verwendet wird. Entsprechend lässt sich auf ein aufwendiges Stapeln mehrerer dünner erster Metallschichten in einem ersten Abschnitt für die ersten Metallschichten verzichten, sodass das Fertigungsverfahren signifikant vereinfacht wird. Dies ist insbesondere deswegen möglich, weil eine dickere erste Metallschicht verwendet werden kann, um die vergleichsweise sehr dünnen Strukturierungen im ersten Teil der mindestens einen Ausnehmung zu realisieren.

Ein weiterer Gegenstand der vorliegenden Erfindung ist ein Kühlelement hergestellt mit dem erfindungsgemäßen Verfahren, wobei ein Abstand zwischen gegenüberliegenden Seitenwänden im ersten Teil der mindestens einen Ausnehmung kleiner als 0,4 mm, bevorzugt kleiner als 0,3 mm und besonders bevorzugt kleiner als 0,2 mm ist. Alle für das Verfahren beschriebenen Eigenschaften und Vorteile lassen sich analog übertragen auf das Kühlelement und andersrum.

Weiterhin ist es nach einer Ausführungsform der Erfindung vorgesehen, dass die stegartigen Elemente gradlinig und/oder schräg und/oder gebogen, insbesondere bezogen auf eine Mittelachse der mindestens einen ersten Metallschicht, in das Kühlfluidkanalsystem hineinragen. Ferner ist es vorstellbar, dass eine Ausrichtung der Stegelemente bzw. der stegartigen Elemente in der mindestens einen ersten Metallschicht sich unterscheidet von der Orientierung bzw. Ausrichtung der stegartigen Elemente in der mindestens einen dritten Metallschicht und/oder mindestens einen zweiten Metallschicht. Vorzugsweise lässt sich die Form und Ausgestaltung der stegartigen Elemente anpassen an die Erfordernisse im jeweiligen Anwendungsfall bzw. für das jeweilige elektrische bzw. elektronische Bauteil. Vorzugsweise ist es vorgesehen, dass der Abstand zwischen gegenüberliegenden Seitenwänden einen Wert zwischen 0,10 und 0,3 mm annimmt, besonders bevorzugt zwischen 0,15 und 0,28 mm und besonders bevorzugt in etwa einen Wert von ungefähr 0,2 annimmt. Neben der Dimensionierung der Abstände zwischen zwei benachbarten stegartigen Elementen, hat es sich zudem als vorteilhaft herausgestellt, den Abstand zwischen diesen nicht zu klein zu gestalten, um nicht in entsprechender Weise die Pumpleistung für das Durchführen des Kühlfluides signifikant zu erhöhen. In entsprechender Weise haben sich die angegebenen Abstände als überraschend vorteilhafte Kompromisse herausgestellt, zwischen einer optimierten Kühleffizienz und einer Pumpleistung, die für das Durchführen des Kühlfluides durch das Kühlfluidkanalsystems erforderlich ist.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigt:
- **Fig. 1:**: schematische Explosionsdarstellung eines Kühlelements gemäß einer ersten beispielhaften Ausführungsform der vorliegenden Erfindung,
- **Fig. 2**: schematische Darstellung einer ersten Metallschicht für ein Kühlelement aus Figur 1,
- **Fig.3:**: schematische Darstellung eines Kühlelements gemäß einer zweiten beispielhaften Ausführungsform der vorliegenden Erfindung und,
- **Fig.4**: schematische Darstellung eines Spannelements für ein Verfahren zur Herstellung eines Kühlelements gemäß einer bevorzugten Ausführungsform der vorliegenden Erfindung.

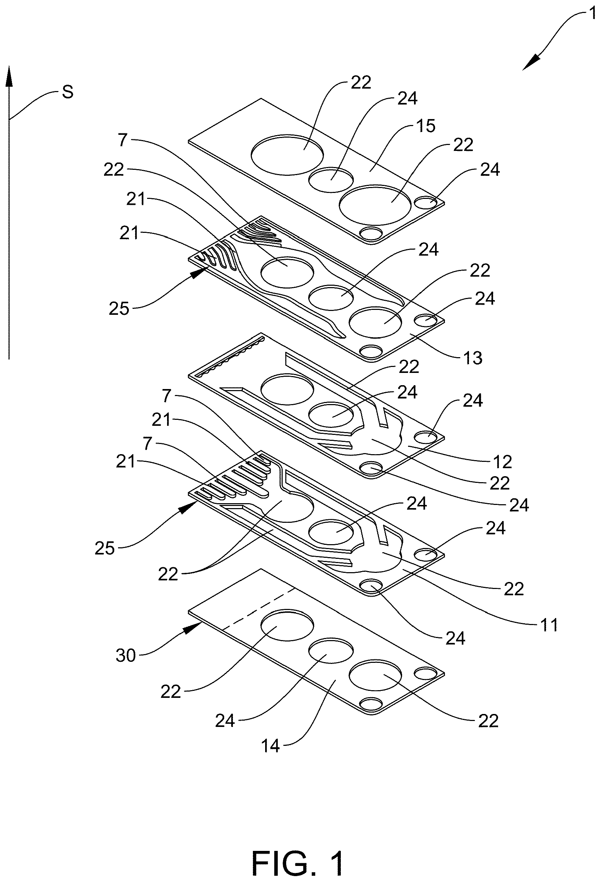

In **Figur 1** ist schematisch eine Explosionsdarstellung eines Kühlelements 1 gemäß einer ersten bevorzugten Ausführungsform der vorliegenden Erfindung dargestellt. Insbesondere handelt es sich bei dem Kühlelement 1 um ein solches, das zum Kühlen eines elektronischen oder elektrischen Bauteils (nicht dargestellt), insbesondere eines Halbleiterelements und besonders bevorzugt einer Laserdiode, vorgesehen ist. Zum Kühlen des elektrischen bzw. des elektronischen Bauteils bildet das gefertigte Kühlelement 1 ein Kühlfluidkanalsystem aus, durch das im Betrieb ein Kühlfluid leitbar ist, so dass das Kühlfluid Wärme, die von dem elektronischen bzw. elektrischen Bauteil im Betrieb ausgeht, aufnehmen und wegführen kann.

Hierzu sind in dem Kühlelement 1, insbesondere im Kühlfluidkanalsystem, vorzugsweise ein Zuleitungsbereich und ein Ableitungsbereich vorgesehen (nicht gezeigt), wobei über den Zuleitungsbereich das Kühlfluid eingeleitet wird und über den Ableitungsbereich wieder ausgeleitet wird. Vorzugsweise ist es vorgesehen, dass das Kühlfluidkanalsystem derart ausgestaltet ist, dass das Kühlfluid 1 beim Übergang vom Zuleitungsbereich zum Ableitungsbereich eine Finnenstruktur 25 passiert, die insbesondere in das Kühlfluidkanalsystem hineinragt. Bei der Finnenstruktur 25 handelt es sich vorzugsweise um stegartige Elemente 7 die in das Kühlfluidkanalsystem hineinragen, um eine möglichst große Kontaktfläche für das Fluid bereitzustellen, sodass eine wirkungsvolle Übertragung der Wärme vom stegartigem Element 7 bzw. der Wandung des Kühlkanalsystems auf das Fluid möglich ist.

Vorzugsweise umfasst das Kühlelement 1 mindestens eine erste Metallschicht 11, mindestens eine zweite Metallschicht 12 und/oder mindestens eine dritte Metallschicht 13. Zur Ausbildung des Kühlfluidkanalsystems sind die mindestens eine erste Metallschicht 11, die mindestens zweite Metallschicht 12 und/oder die mindestens dritte Metallschicht 13 durch mindestens eine Ausnehmung 21, 22 derart strukturiert, dass sie durch ein Aufeinanderstapeln bzw. ein übereinanderlegen entlang der Stapelrichtung S das Kühlfluidkanalsystem ausbildet.

Dabei ist es insbesondere vorgesehen, dass die mindestens eine erste Metallschicht 11, die mindestens eine zweite Metallschicht 12 und/oder die mindestens eine dritte Metallschicht 13 jeweils anders strukturiert sind bzw. mit anders verlaufenden Ausnehmungen 21, 22 ausgestattet sind. Insbesondere ist es vorgesehen, dass die mindestens eine erste Metallschicht 11, die mindestens eine zweite Metallschicht 12 und/oder die mindestens eine dritte Metallschicht 13 mindestens einen ersten Teil 21 in der mindestens einen Ausnehmung 21, 22 ausformt, der die stegartigen Elemente 7 aufweist, die insbesondere sich in einer senkrecht zur Stapelrichtung S verlaufenden Haupterstreckungsebene HSE erstrecken. Neben dem ersten Teil 21 der mindestens einen Ausnehmung 21, 22 in der mindestens einen ersten Metallschicht 11 ist es vorzugsweise vorgesehen, dass ein zweiter Teil 22 der mindestens einen Ausnehmung 21, 22 in der mindestens einen ersten Metallschicht 11 für das Zuleiten oder Ableiten des Kühlfluides in den ersten Teil 21 bzw. aus dem ersten Teil 21 vorgesehen ist bzw. einen Teil des Zuleitungsbereich und/oder Ableitungsbereichs bildet.

Das Kühlelement 1 wird vorzugsweise in Stapelrichtung S durch eine obere Deckschicht 15 und eine untere Deckschicht 14 begrenzt, wobei die erste mindestens eine erste Metallschicht 11, die mindestens eine zweite Metallschicht 12 und/oder die mindestens eine dritte Metallschicht 13 in Stapelrichtung S gesehen zwischen der unteren Deckschicht 14 und der oberen Deckschicht 15 angeordnet ist. Insbesondere ist die Formation aus der mindestens einen ersten Metallschicht 11, der mindestens einen zweiten Metallschicht 12 und/oder der mindestens einen dritten Metallschicht 13 sandwichartig zwischen der oberen Deckschicht 15 und der unteren Deckschicht 14 angeordnet. Neben der mindestens einen Ausnehmung 21, 22, die sich zusammensetzt aus dem ersten Teil 21 und dem zweiten Teil 22, ist es vorzugsweise vorgesehen, dass das Kühlelement 1 bzw. die mindestens eine erste Metallschicht 11 eine weitere Ausnehmung 24 aufweist, die kein Bestandteil des Kühlfluidkanalsystems, mit der Finnenstruktur 25 ist. Weiterhin ist es vorzugsweise vorgesehen, dass an der oberen Deckschicht 15 und/oder der unteren Deckschicht 14 eine Anschlussfläche 30 vorgesehen ist. Insbesondere wird an dieser Anschlussfläche 30 das elektrische bzw. elektronische Bauteil angebunden, insbesondere in Stapelrichtung S gesehen, oberhalb bzw. unterhalb der Finnenstruktur 25, die sich vorzugsweise in einer senkrecht zur Stapelrichtung S verlaufenden Richtung erstreckt. Mit anderen Worten: die Finnenstruktur 25, insbesondere deren stegartigen Elemente 7, erstreckt sich unterhalb der Anschlussfläche 30 und vorzugsweise parallel dazu. Durch die entsprechende Anordnung der Finnenstruktur 25 aus den stegartigen Elementen 7 oberhalb bzw. unterhalb der Anschlussfläche 30 lässt sich das elektrische bzw. das elektronische Bauteil wirkungsvoll mittels der Finnenstruktur 25 kühlen.

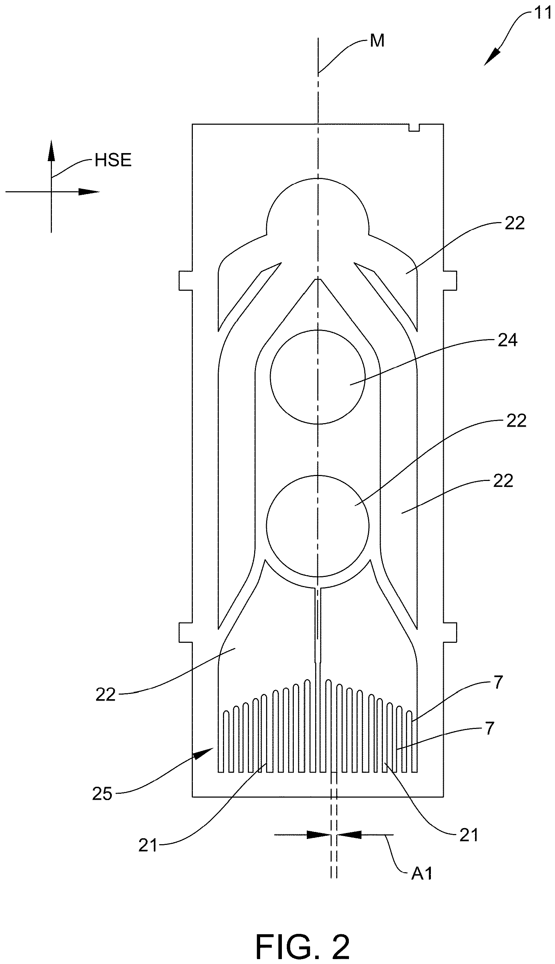

In Figur 2 ist eine schematische Darstellung einer mindestens einen ersten Metallschicht 11 dargestellt, die beispielsweise in Figur 1 verbaut ist. In der dargestellten Ausführungsform ist die Finnenstruktur 25 aus stegartigen Elementen 7 ausgebildet, die sich in Haupterstreckungsebene HSE gesehen, unterschiedlich weit erstrecken. Insbesondere nimmt eine Länge der stegartigen Elemente 7 zu einer Mittelachse M der mindestens einen ersten Metallschicht 11 zu. Dadurch ist es in vorteilhafter Weise möglich, die Kühlwirkung insbesondere im Zentralbereich der Anschlussfläche 30 möglichst zu maximieren. Ferner ist es vorstellbar, dass die stegartigen Elemente parallel und/oder schräg zur Mittelachse M verlaufen. Vorzugsweise wird die Form der stegartigen Elemente 7 insbesondere deren Länge und/oder Neigung gegenüber der Mittelachse M entlang der Haupterstreckungsebene HSE durch das entsprechende Anforderungsprofil für das Kühlen des entsprechenden elektrischen oder elektronischen Bauteils bestimmt bzw. festgelegt.

Um einen möglichst geringen Abstand A1 zwischen zwei benachbarten stegartigen Elementen 7 zu erzielen, ist es vorgesehen, dass der erste Teil 21 der mindestens einen Ausnehmung 21, 22 in der mindestens einen ersten Metallschicht 11 durch ein Erodieren, insbesondere Funkenerodieren, erfolgt. Insbesondere handelt es sich dabei um ein Herstellen mittels Drahterodieren.

Ferner ist es vorgesehen, dass ein zweiter Teil 22 der mindestens einen Ausnehmung 21, 22 durch ein Ätzen erfolgt. Vorzugsweise wird das Ätzen insbesondere in großflächigen Bereichen des zweiten Teils 22 der Ausnehmung 21, 22 durchgeführt, d. h. in den späteren Zuführ- und/der Ableitbereichen, die für das Zuführen und das Ableiten des Kühlfluids ausgebildet sind. Im Gegensatz dazu ist es insbesondere vorgesehen, dass das Erodieren für die feinstrukturierte Ausformung der Ausnehmung 21, 22, d. h. den ersten Teil 21 der Ausnehmung 21, 22 vorgesehen ist. Es hat sich herausgestellt, dass dadurch vergleichsweise sehr geringe Abstände zwischen den stegartigen Elementen 7 hergestellt werden können, ohne dass man auf mehrere erste Metallschichten 11 mit geätzten ersten Teilen 21 der mindestens einen Ausnehmung 21, 22 angewiesen wäre, die übereinander gestapelt werden müssten, um einen möglichst geringen Abstand zwischen zwei stegartigen Elementen 7 zu realisieren. Vorzugsweise ist der Abstand A1 zwischen gegenüberliegenden Seitenwänden zwischen zwei stegartigen Elementen 7 kleiner als 0,4 mm, bevorzugt kleiner als 0,3 mm und besonders bevorzugt kleiner als 0,2 mm. Dadurch lassen sich möglichst viele stegartige Elemente 7 in die Finnenstruktur 25 integrieren. Entsprechend ist es möglich, die Kühlwirkung zu erhöhen, da die Kontaktfläche zwischen Kühlfluid und Wandlung des Kühlfluidkanalsystems in entsprechender Weise erhöht werden kann.

Vorzugsweise weisen die mindestens eine erste Metallschicht 11, die mindestens eine zweite Metallschicht 12, die mindestens eine dritte Metallschicht 13, die obere Deckschicht 15 und/oder die untere Deckschicht 14 eine in Stapelrichtung S gemessene Dicke zwischen 0,2 und 0,7 mm, bevorzugt zwischen 0,35 und 0,6 mm und besonders bevorzugt zwischen 0,3 und 0,4 mm auf. Vorzugsweise bilden die mindestens eine erste Metallschicht 11, die mindestens eine zweite Metallschicht 12 und/oder die mindestens eine dritte Metallschicht 13 jeweils dieselbe Dicke aus. Weiterhin ist es bevorzugt vorgesehen, dass die mindestens eine erste Metallschicht 11, die mindestens eine zweite Metallschicht 12 und/oder die mindestens eine dritte Metallschicht 13 im Rahmen eines Sinterverfahrens zu einem integralen Kühlfluidkanalsystem geformt werden, indem durch eine entsprechende Temperaturbehandlung die Gefüge der mindestens einen ersten Metallschicht 11, der mindestens einen zweiten Metallschicht 12 und/oder der mindestens einen dritten Metallschicht 13 ineinander übergehen bzw. miteinander verschmelzen. Weiterhin ist es vorgesehen, dass auch die obere Deckschicht 15 und/oder die untere Deckschicht 14 jeweils mindestens eine Ausnehmung 21, 22 und/oder eine weitere Ausnehmung 24 aufweisen, wobei die obere Deckschicht 15 und/oder die untere Deckschicht 14 vorzugsweise frei sind von stegartigen Elementen 7 bzw. Bestandteilen einer späteren Finnenstruktur 25. Die weiteren Ausnehmungen 24 dienen vorzugsweise der Befestigung oder Fixierung des Kühlelements 1.

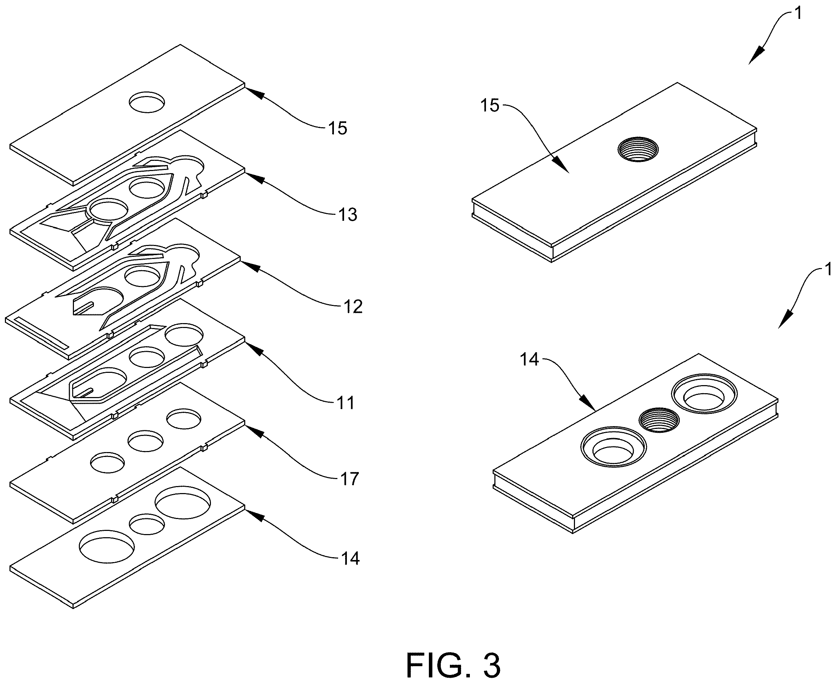

In Figur 3 ist ein Kühlelement 1 gemäß einer zweiten bevorzugten Ausführungsform vorgesehen. Dabei entspricht das Kühlelement 1 im Wesentlichen demjenigen Kühlelement 1 aus der Figur 1 und unterscheidet sich im Wesentlichen nur dahingehend, dass die untere Deckschicht 14 und/oder die obere Deckschicht 15 als Metall-Keramik-Verbund ausgebildet ist. Insbesondere ist es dabei vorgesehen, dass die obere Deckschicht 15 und/oder die untere Deckschicht 14 jeweils eine Keramikschicht aufweisen, vorzugsweise aus Aluminiumnitrid, die beispielsweise beidseitig mit einer Metallschicht, vorzugsweise einer Kupferschicht, bedeckt ist. Beispielsweise handelt es sich um eine Keramikschicht aus Aluminiumnitrid, deren Dicke in Stapelrichtung S bemessen einen Wert von 0,1 mm bis 0,5 mm, vorzugsweise 0,2 mm bis 0,4 mm und besonders bevorzugt von im Wesentlichen 0,38 mm annimmt, während die außenliegenden Metallschichten, die die Keramikschicht jeweils bedecken, eine Dicke zwischen 0,05 und 0,4 mm, bevorzugt zwischen 0,1 und 0,3 mm und besonders bevorzugt zwischen 0,15 und 0,25 mm aufweisen.

Dabei ist es insbesondere vorgesehen, dass die Metallschichten, die an gegenüberliegenden Seiten der Keramikschicht ausgebildet sind, unterschiedlich dick sind. Beispielsweise weist die eine Metallschicht eine Kupferdicke von 0,2 mm auf, während die gegenüberliegende Kupferschicht eine Dicke von 0,12 mm aufweist, die insbesondere durch ein Diamantschleifen nach dem Anbindungsprozess der Metallschicht an die Kupferschicht realisiert ist. Vorzugsweise handelt es sich bei der oberen Deckschicht 15 und/oder der unteren Deckschicht 14 um ein Metall-Keramik-Verbund, der mittels eines DCB-Verfahrens hergestellt wurde.

Weiterhin ist es bevorzugt vorgesehen, dass das Kühlelement 1 aus Figur 3 eine Dichtelementträgerschicht 17 aufweist, in der bzw. mit der beispielsweise O-Ringe fixiert werden können, um eine entsprechende Abdichtung im Anschlussbereich für den Zuführ- und den Ableitbereich des Kühlelements 1 zu gewährleisten. Vorzugsweise handelt es sich bei der Dichtelementträgerschicht 17 um eine Metallschicht mit entsprechenden Ausnehmungen 21, 22 bzw. weiteren Ausnehmungen 24, wobei die Dichtelementträgerschicht 17 eine in Stapelrichtung bemessene Dicke zwischen 0,1 und 0,4 mm, bevorzugt zwischen 0,1 und 0,4 mm und besonders bevorzugt zwischen 0,2 und 0,3 mm aufweisen kann.

Darüber hinaus unterscheidet sich die Ausführungsform aus Figur 3 von derjenigen aus der Figur 1 dahingehend, dass das Kühlelement 1 an seiner oberen Deckschicht 15 geschlossen ist und eine Eingangsöffnung für das Zuführen des Kühlfluides und eine Ausgangsöffnung zum Abführen des Kühlfluides ausschließlich an der unteren Deckschicht 14 ausgebildet sind, sodass das Kühlfluid das über die untere Deckschicht 14 in das Kühlelement 1 eingeleitet wird, diese entlang der Stapelrichtung S durchsetzt und in der mindestens einen dritten Metallschicht 13 umgelenkt wird, um dann in entgegengesetzter Richtung das Kühlelement 1 wieder zu verlassen. Die obere Deckschicht 15 und untere Deckschicht 14 aus einem Metall-Keramik-Verbund erweist sich insbesondere vorteilhaft für solche Anwendungsfälle, in denen das Kühlelement 1 elektrisch isoliert werden muss, von dem Bauelement, welches auf dem Kühlelement 1 bzw. an das Kühlelement 1 angebunden ist.

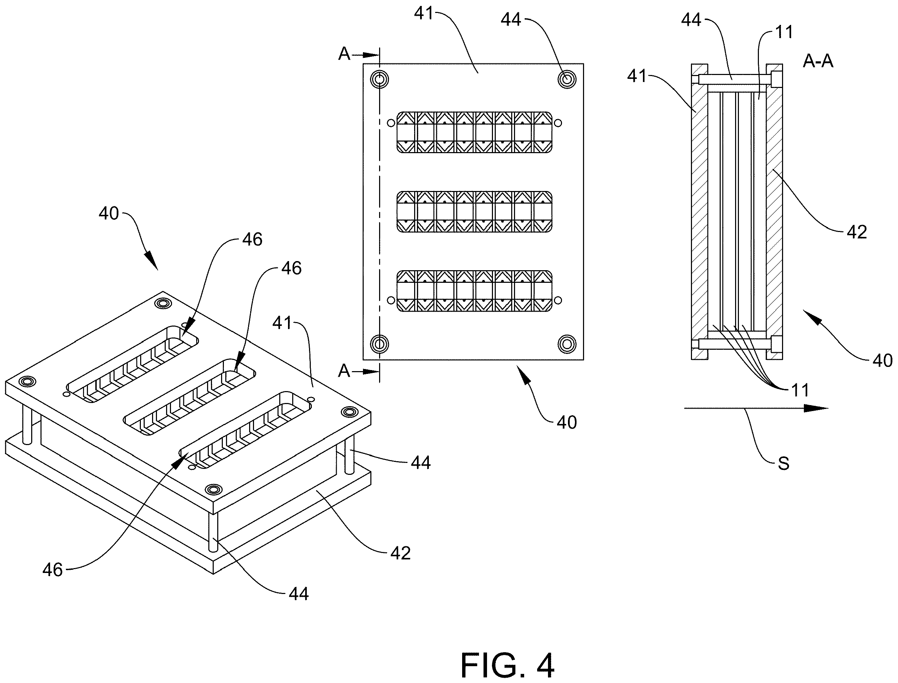

In Figur 4 ist eine schematische Darstellung eines Spannelements 40 für ein Verfahren zur Herstellung eines Kühlelements 1 gemäß einer bevorzugten Ausführungsform der vorliegenden Erfindung dargestellt. Insbesondere ist es dabei vorgesehen, dass das Spannelement 40 dazu ausgelegt ist, mehrere erste Metallschichten 11 aufzunehmen. Insbesondere sind im Spannelement 40 mehrere erste Metallschichten 11 entlang der Stapelrichtung S übereinander angeordnet. Vorzugsweise werden bis zu 20 erste Metallschichten 11, bevorzugt bis zu 30 erste Metallschichten und besonders bevorzugt bis zu 40 erste Metallschichten 11 im Spannelement 40 entlang der Stapelrichtung S übereinander angeordnet und zwischen einer ersten Fixierhälfte 41 und einer zweiten Fixierhälfte 42 sandwichartig verklemmt.

Dabei ist es insbesondere vorgesehen, dass die erste Fixierhälfte 41 und die zweite Fixierhälfte 42 als plattenartige Bauteile ausgebildet sind, die einander gegenüberliegend angeordnet sind und besonders bevorzugt jeweils Öffnungen 46 aufweisen, insbesondere fenster- oder lukenartige artige Öffnungen 46 aufweisen, die es gestatten, Zugriff zu gewähren auf die zwischen der ersten Fixierhälfte 41 und der zweiten Fixierhälfte 42 angeordneten ersten Metallschichten 11. Dadurch ist es möglich, dass die zwischen der ersten Fixierhälfte 41 und der zweiten Fixierhälfte 42 angeordneten ersten Metallschichten 11 zur Ausbildung zumindest des jeweiligen ersten Teils 21 der mindestens einen Ausnehmung 21, 22 in der mindestens ersten Metallschicht 11 gemeinsam erodiert werden.

Vorzugsweise sind die ersten Metallschichten 11, bevor sie zwischen der ersten Fixierhälfte 41 und der zweiten Fixierhälfte 42 verspannt werden, bereits mit einer eingeätzten bzw. angeätzten Struktur versehen, die im späteren gefertigten Zustand der ersten Metallschicht 11 vor dem Zusammensetzen zum Kühlelemente vorzugsweise den zweiten Teil 21 der mindestens einen Ausnehmung 21, 22 bereitstellt. Entsprechend lässt sich dadurch die Möglichkeit realisieren, großflächige Abschnitte in der mindestens einen Ausnehmung 21, 22 in der mindestens einen ersten Metallschicht 11 durch ein großflächiges Ätzen zu realisieren, während die feinstrukturierten stegartigen Elemente 7 durch das gemeinsame Drahterodieren realisiert werden. Weiterhin ist es in vorteilhafter Weise möglich, durch das Spannelement 40 die bereits vorgeätzten ersten Metallschichten 11 dem Erodieren gemeinsam bereitzustellen bzw. die ersten Metallschichten 11 in diesem Spannelement 40 geeignet zu transportieren. Dabei ist es besonders bevorzugt vorgesehen, dass die erste Fixierhälfte 41 und die zweite Fixierhälfte 42 über ein entsprechendes Befestigungsmittel 44 miteinander verbunden sind bzw. derart verbunden sind, dass sie die zwischen ihnen angeordneten ersten Metallschichten 11 fixieren. Beispielsweise handelt es sich bei dem Befestigungsmittel 44 um eine Schraube.

Vorzugsweise ist an jeder Ecke des Spannelements 40 ein Befestigungsmittel 44 zum gleichmäßigen Festziehen vorgesehen. Dabei ist es insbesondere vorgesehen, dass das Befestigungsmittel 44 die mehreren ersten Metallschichten 11 möglichst unabhängig von der genauen Anzahl der ersten Metallschichten 11 ausreichend fixieren kann. D. h. der Abstand zwischen der ersten Fixierhälfte 41 und der zweiten Fixierhälfte 42 lässt sich insbesondere durch das entsprechende Befestigungsmittel 44 variable einstellen, sodass entsprechende Abweichungen in der Anzahl der ersten Metallschichten 11 einfach ausgeglichen werden können. Die gemeinsam erodierten ersten Metallschichten 11 lassen sich dann jeweils zur Ausbildung jeweils eines Kühlelements 1 nutzen, das bevorzugt lediglich eine einzelne erste Metallschicht 11 benötigt. Das hier beschriebene Vorgehen für die mindestens eine erste Metallschicht 11 lässt sich selbstverständlich in analoger Weise auf die mindestens eine zweite Metallschicht 12 und/oder die mindestens eine dritte Metallschicht 13 übertragen.

### Bezugszeichenliste-.

- 1: Kühlelement
- 7: stegartiges Element
- 11: erste Metallschicht
- 12: zweite Metallschicht
- 13: dritte Metallschicht
- 14: untere Deckschicht
- 15: obere Deckschicht,
- 17: Dichtelementträgerschicht
- 21: erster Teil der Ausnehmung
- 22: zweiter Teil der Ausnehmung
- 24: weitere Ausnehmung
- 25: Finnenstruktur
- 30: Anschlussfläche
- 40: Spannelement
- 41: erste Fixierhälfte
- 42: zweite Fixierhälfte
- 44: Befestigungsmittel
- 46: Öffnung
- A1: Abstand
- S: Stapelrichtung
- M: Mittelachse
- HSE: Haupterstreckungsebene

## Patentansprüche

1. Verfahren zur Herstellung eines Kühlelements (1) für ein elektrisches oder elektronisches Bauteil, insbesondere ein Halbleiterelement, wobei das gefertigte Kühlelement (1) ein Kühlfluidkanalsystem aufweist, durch das im Betrieb ein Kühlfluid durchleitbar ist, umfassend
- Bereitstellen mindestens einer ersten Metallschicht (11),
- Realisieren mindestens einer Ausnehmungen (21, 22) in der mindestens einen ersten Metallschicht (11), und
- Ausbilden zumindest eines Teilabschnitts des Kühlfluidkanalsystem mittels der mindestens einen Ausnehmung (21, 22),
wobei mindestens ein erster Teil (21) der mindestens einen Ausnehmung (21, 22) in der mindestens einen ersten Metallschicht (11) durch Erodieren, insbesondere Funkenerodieren, realisiert wird, **dadurch gekennzeichnet, dass** mindestens ein zweiter Teil (22) der mindestens einen Ausnehmung (21, 22) in der mindestens einen ersten Metallschicht (11) durch ein Ätzen realisiert wird.

2. Verfahren gemäß Anspruch 1, weiter umfassend:
- Bereitstellen mindestens einer zweiten Metallschicht (12) und
- Stapeln der mindestens einen ersten Metallschicht (11) und der mindestens einen zweiten Metallschicht (12) entlang einer Stapelrichtung (S), unter Ausbildung des mindestens einen Teilabschnitts des Kühlfluidkanalsystems.

3. Verfahren gemäß Anspruch 1, wobei das Ätzen zur Ausbildung des mindestens einen zweiten Teils (22) der mindestens einen Ausnehmung (21, 22) in der mindestens einen ersten Metallschicht (11) zeitlich vor dem Bilden des mindestens einen ersten Teils (21) der mindestens einen Ausnehmung (21, 22) in der mindestens einen ersten Metallschicht (11) durch das Erodieren erfolgt.

4. Verfahren gemäß einem der vorhergehenden Ansprüche, wobei mehrere erste Metallschichten (11) gleichzeitig erodiert werden.

5. Verfahren gemäß Anspruch 4, wobei die mehreren ersten Metallschichten (11) in einem Spannelement (40) fixiert werden.

6. Verfahren gemäß einem der vorhergehenden Ansprüche, wobei die mindestens eine erste Metallschicht (11) eine Dicke von mehr als 0,3 mm, bevorzugt mehr als 0,4 mm und besonders bevorzugt mehr als 0,8 mm aufweist.

7. Verfahren gemäß einem der vorhergehenden Ansprüche, wobei die mindestens eine erste Metallschicht (11) und/oder die mindestens eine zweite Metallschicht (12) zwischen einer unteren Deckschicht (14) und einer oberen Deckschicht (15) angeordnet wird.

8. Verfahren gemäß einem der vorhergehenden Ansprüche, wobei mehr als drei, bevorzugt mehr als fünf und besonders bevorzugt mehr als sieben erste Metallschichten (11) und/oder zweite Metallschicht (12) vorgesehen sind, deren Dicke größer ist als 0,3 mm.

9. Verfahren gemäß einem der vorhergehenden Ansprüche, wobei alle erste Metallschichten (11) und/oder zweite Metallschichten (12) eine Dicke von mehr als 0,3 mm, bevorzugt mehr als 0,4 mm und besonders bevorzugt mehr als 0,8 mm aufweisen.

10. Verfahren gemäß einem der vorhergehenden Ansprüche, wobei die Formen der mindestens einen Ausnehmung (21, 22) für mindestens drei, bevorzugt mindestens fünf und besonders bevorzugt mindestens acht erste Metallschichten (21) unterschiedlich sind.

11. Verfahren gemäß einem der vorhergehenden Ansprüche, wobei die mindestens eine erste Metallschicht (11) mit der mindestens zweiten Metallschicht (12), vorzugsweise durch Sintern, verbunden wird.

12. Verfahren gemäß einem der vorhergehenden Ansprüche, wobei eine einzige erste Metallschicht (11) zur Bildung des Kühlelements (1) verwendet wird.

13. Kühlelement (1) hergestellt mit einem Verfahren gemäß einem der vorhergehenden Ansprüche, wobei ein Abstand (A1) zwischen gegenüberliegenden Seitenwänden in der mindestens einen ersten Metallschicht (11) zumindest bereichsweise kleiner als 0,4 mm, bevorzugt kleiner als 0,3 mm und besonders bevorzugt kleiner als 0,2 mm ist.

## Claims

1. A method for producing a cooling element (1) for an electrical or electronic component, in particular a semiconductor element, wherein the produced cooling element (1) has a cooling fluid channel system in which a cooling fluid is passed through during operation, comprising
- providing at least a first metal layer (11),
- creating at least one recess (21, 22) in the at least one first metal layer (11), and
- forming at least a partial section of the cooling fluid channel system using the at least one recess (21, 22),
wherein at least a first portion (21) of the at least one recess (21, 22) in the at least one first metal layer (11) is realized by erosion, in particular spark erosion, **characterized in that** at least a second portion (22) of the at least one recess (21, 22) in the at least one first metal layer (11) is realized by etching.

2. The method according to claim 1, further comprising:
- providing at least one second metal layer (12); and
- stacking the at least one first metal layer (11) and the at least one second metal layer (12) along a stacking direction (S) on top of each other to form the at least one partial section of the cooling fluid channel system.

3. The method according to claim 1, wherein etching to form the at least one second portion (22) of the at least one recess (21, 22) in the at least one first metal layer (11) is performed prior to forming the at least one first portion (21) of the at least one recess (21, 22) in the at least one first metal layer (11) by the eroding.

4. The method according to one of the preceding claims, wherein a plurality of first metal layers (11) are simultaneously eroded.

5. The method according to claim 4, wherein the said plurality of first metal layers (11) are fixed in a chucking element (40).

6. The method according to one of the preceding claims, wherein the at least one first metal layer (11) has a thickness of more than 0.3 mm, preferably more than 0.4 mm and especially preferably more than 0.8 mm.

7. The method according to one of the preceding claims, wherein the at least one first metal layer (11) and/or the at least one second metal layer (12) is arranged between a lower cover layer (14) and an upper cover layer (15).

8. The method according to one of the preceding claims, wherein more than three, preferably more than five and especially preferably more than seven first metal layers (11) and/or second metal layer (12) are provided, the thickness of which is greater than 0.3 mm.

9. The method according to one of the preceding claims, wherein all of the first metal layers (11) and/or second metal layers (12) have a thickness of more than 0.3 mm, preferably more than 0.4 mm and especially preferably more than 0.8 mm.

10. The method according to one of the preceding claims, wherein the shapes of the at least one recess (21, 22) are different for at least three, preferably at least five and especially preferably at least eight first metal layers (21).

11. The method according to one of the preceding claims, wherein the at least one first metal layer (11) is bound to the at least one second metal layer (12), preferably by sintering.

12. The method according to one of the preceding claims, wherein one single first metal layer (11) is used to form the cooling element (1).

13. A cooling element (1) produced by a method according to one of the preceding claims, wherein a distance (A1) between opposite side walls in the at least one first metal layer (11), at least in some areas, is smaller than 0.4 mm, preferably smaller than 0.3 mrn and especially preferably smaller than 0.2 mm.

## Revendications

1. Procédé de fabrication d'un élément de refroidissement (1) pour un composant électrique ou électronique, en particulier un élément semiconducteur, l'élément de refroidissement (1) fabriqué présentant un système de canaux pour fluide de refroidissement susceptible d'être traversé, en fonctionnement, par un fluide de refroidissement, comprenant à
- fournir au moins une première couche métallique (11),
- réaliser au moins un évidement (21, 22) dans ladite au moins une première couche métallique (11), et
- former au moins une portion partielle du système de canaux pour fluide de refroidissement au moyen dudit au moins un évidement (21, 22),
au moins une première partie (21) dudit au moins un évidement (21, 22) dans ladite au moins une première couche métallique (11) étant réalisée par érosion, en particulier par électroérosion,
**caractérisé en ce qu'**au moins une deuxième partie (22) dudit au moins un évidement (21, 22) dans ladite au moins une première couche métallique (11) est réalisée par attaque chimique.

2. Procédé selon la revendication 1, comprenant en outre à :
- fournir au moins une deuxième couche métallique (12), et
- empiler ladite au moins une première couche métallique (11) et de ladite au moins une deuxième couche métallique (12) le long d'une direction d'empilement (S), en formant ladite au moins une portion partielle du système de canaux pour fluide de refroidissement.

3. Procédé selon la revendication 1,
dans lequel l'attaque chimique pour former ladite au moins une deuxième partie (22) dudit au moins un évidement (21, 22) dans ladite au moins une première couche métallique (11) est réalisée temporellement avant la formation par érosion de ladite au moins une première partie (21) dudit au moins un évidement (21, 22) dans ladite au moins une première couche métallique (11).

4. Procédé selon l'une des revendications précédentes,
dans lequel plusieurs premières couches métalliques (11) sont érodées simultanément.

5. Procédé selon la revendication 4,
dans lequel lesdites plusieurs premières couches métalliques (11) sont fixées dans un élément de serrage (40).

6. Procédé selon l'une des revendications précédentes,
dans lequel ladite au moins une première couche métallique (11) a une épaisseur supérieure à 0,3 mm, de préférence supérieure à 0,4 mm et de manière particulièrement préférée supérieure à 0,8 mm.

7. Procédé selon l'une des revendications précédentes,
dans lequel ladite au moins une première couche métallique (11) et/ou ladite au moins une deuxième couche métallique (12) est disposée entre une couche de revêtement inférieure (14) et une couche de revêtement supérieure (15).

8. Procédé selon l'une des revendications précédentes,
dans lequel il est prévu plus de trois, de préférence plus de cinq et de manière particulièrement préférée plus de sept premières couches métalliques (11) et/ou deuxièmes couches métalliques (12), dont l'épaisseur est supérieure à 0,3 mm.

9. Procédé selon l'une des revendications précédentes,
dans lequel toutes les premières couches métalliques (11) et/ou toutes les deuxièmes couches métalliques (12) ont une épaisseur supérieure à 0,3 mm, de préférence supérieure à 0,4 mm et de manière particulièrement préférée supérieure à 0,8 mm.

10. Procédé selon l'une des revendications précédentes,
dans lequel les formes dudit au moins un évidement (21, 22) sont différentes pour au moins trois, de préférence au moins cinq et de manière particulièrement préférée au moins huit premières couches métalliques (21).

11. Procédé selon l'une des revendications précédentes,
dans lequel ladite au moins une première couche métallique (11) est reliée à ladite au moins une deuxième couche métallique (12) de préférence par frittage.

12. Procédé selon l'une des revendications précédentes,
dans lequel une seule première couche métallique (11) est utilisée pour former l'élément de refroidissement (1).

13. Elément de refroidissement (1) fabriqué par un procédé selon l'une des revendications précédentes,
dans lequel une distance (A1) entre des parois latérales opposées dans ladite au moins une première couche métallique (11) est au moins localement inférieure à 0,4 mm, de préférence inférieure à 0,3 mm et de manière particulièrement préférée inférieure à 0,2 mm.
